# FASCICULE DE BREVET EUROPEEN

(11) **EP 1 338 030 B1**
(45) Date de publication et mention de la délivrance du brevet: **22.06.2011**
(21) Numéro de dépôt: 01997839.4
(22) Date de dépôt: 26.11.2001
(51) Int. Cl.: H01L 21/20, H01L 21/302, H01L 29/165, H01L 29/205, H01L 29/267

(54) **PROCEDE DE FABRICATION D'UN SUBSTRAT NOTAMMENT POUR L'OPTIQUE, L'ELECTRONIQUE OU L'OPTOELECTRONIQUE ET SUBSTRAT OBTENU PAR CE PROCEDE**
VERFAHREN ZUR HERSTELLUNG EINES SUBSTRATS INBESONDERE FÜR OPTIK,ELEKTRONIK ODER OPTOELEKTRONIK UND DANACH HERGESTELLTES SUBSTRAT
METHOD FOR MAKING A SUBSTRATE IN PARTICULAR FOR OPTICS, ELECTRONICS OR OPTOELECTRONICS AND RESULTING SUBSTRATE

(30) Priorité: 27.11.2000 FR 0015280
(43) Date de publication de la demande: 27.08.2003
(73) Titulaire: S.O.I.Tec Silicon on Insulator Technologies, 38190 Bernin (FR)
(72) Inventeur: GHYSELEN, Bruno, F-38170 Seyssinet (FR); LETERTRE, Fabrice, F-38000 GRENOBLE (FR)
(74) Mandataire: Le Forestier, Eric
(86) Numéro de dépôt international: PCT/FR2001/003715
(87) Numéro de publication internationale: WO 2002/043124

(56) Documents cités:
- EP-A- 0 528 229
- EP-A- 0 849 788
- EP-A- 0 924 769
- EP-A- 0 928 032
- FR-A- 2 775 121
- FR-A- 2 787 919
- US-A- 4 983 251
- US-A- 6 010 579
- US-A- 6 107 213
- US-A- 6 114 188

## Description

L'invention concerne le domaine des procédés de fabrication de substrats, notamment pour l'optique, l'électronique ou l'optoélectronique, ainsi que celui des substrats obtenus par de tels procédés. Plus particulièrement, il peut s'agir de substrats destinés à la réalisation de microsystèmes, de capteurs, de diodes électroluminescentes ou laser, etc.

On connaît déjà, notamment par le document FR 2 681 472, un procédé de fabrication de substrats dans lequel on transfère une couche mince d'un matériau d'un substrat source sur un support. Dans ce cas, l'opération de collage entre la couche mince et le support est souvent réalisée par adhésion moléculaire et nécessite pour obtenir une bonne interface de collage, une préparation spécifique des surfaces à coller, préalablement à leur mise en contact. Or, cette préparation, qui comprend généralement des opérations de polissage, de planarisation, de traitement physico-chimique, de réalisation de couches intermédiaires, etc., peut être relativement longue et complexe. C'est en particulier le cas, lorsque le substrat support est polycristallin. En plus, le document FR-A-2 787 919 décrit un procédé selon la préambule de la revendication 1.

Un but de l'invention est de fournir un procédé de fabrication d'un substrat comprenant une couche mince sur un support, qui soit sensiblement simplifié par rapport aux procédés de l'art antérieur et qui puisse être beaucoup plus économique.

Ce but est atteint, selon l'invention, grâce à un procédé de fabrication d'un substrat selon la revendication 1.

Le procédé selon l'invention est simple à mettre en oeuvre et permet de s'affranchir de préparations longues et coûteuses des surfaces à mettre en contact, telles que le polissage, la planarisation, la réalisation de couches intermédiaires, etc., toutes ces étapes pouvant être éventuellement remplacées par un simple décapage avant la formation de la couche épaisse, qui peut avantageusement être accompagné d'un traitement à haute température.

En particulier, alors que dans les techniques existantes de report d'une couche mince sur un support épais, qu'il soit monocristallin, polycristallin, amorphe, etc., on reporte une couche mince monobloc sur un support épais, également monobloc, réalisé avant assemblage, le support épais est formé selon la présente invention directement sur la couche mince. Ainsi la mise en oeuvre du procédé selon l'invention, parce qu'il permet de s'affranchir d'étapes longues et coûteuses de préparation des surfaces, génère des économies substantielles.

Avantageusement, selon l'invention, on réalise un dépôt direct du matériau constitutif du support, sur la couche mince, par exemple par dépôt chimique en phase vapeur (aussi appelée par l'homme du métier « CVD », acronyme de l'expression anglo-saxonne Chemical Vapor Deposition). Dans ce cas, on obtient une interface d'excellente qualité entre la couche mince et le support, notamment en terme de conductivité électrique et/ou thermique, ce qui n'était généralement pas réalisable avec les procédés de l'art antérieur.

La couche épaisse peut aussi correspondre à un dépôt de métal, par exemple un dépôt électrolytique de cuivre.

Mais la couche épaisse peut également être formée à partir d'un matériau en fusion et/ou visqueux ou fritté.

Le procédé selon l'invention est avantageusement mis en oeuvre pour réaliser des substrats dans lesquels la couche mince et la couche épaisse sont constituées de matériaux possédant respectivement des coefficients de dilatation thermique et / ou des paramètres cristallins proches ou égaux.

Le procédé selon l'invention est aussi particulièrement intéressant dans le cadre de la réalisation de substrats composites comportant une couche mince monocristalline, par exemple en matériau semi-conducteur, sur un substrat - support polycristallin, amorphe, céramique, multi-phasé, etc. En effet, certaines techniques, notamment de dépôt et/ou de croissance, permettent la formation de couches épaisses à des coûts faibles. Ainsi, la formation d'une couche épaisse de carbure de silicium polycristallin ou amorphe par exemple, sur une couche mince de carbure de silicium monocristallin, par le procédé selon l'invention, permet la formation de substrats de carbure de silicium, à un coût plus bas que si ces substrats étaient totalement en carbure de silicium monocristallin de bonne qualité.

En outre, le procédé selon l'invention a pour avantage de favoriser la croissance d'un matériau constitutif du support, de bonne qualité. Ainsi, lorsque l'on souhaite réaliser des substrats à moindre coût, il est possible, par les procédés de l'art antérieur, de transférer une couche mince monocristalline sur un support peu coûteux, tel qu'un support en matériau polycristallin ou amorphe. Lorsque l'on transpose cette idée au procédé selon l'invention, on réalise une couche épaisse de matériau peu coûteux sur une couche mince d'un matériau à plus forte valeur ajoutée, mais si cette couche mince est monocristalline, la couche épaisse sera de meilleure qualité que si l'on avait transféré une couche monobloc du même matériau que celui de cette couche épaisse, directement sur la couche mince. En effet, si le support, c'est à dire la couche épaisse que l'on forme par le procédé selon l'invention, est un polycristal, on obtiendra, en son sein, une meilleure cohésion et une meilleure orientation des différents grains, ainsi que la croissance de phases privilégiées. Cet avantage peut par contre être amoindri si le procédé selon l'invention comporte une opération de formation d'une couche intermédiaire, un isolant amorphe par exemple, entre la couche mince et le support.

Dans certaines conditions de croissance de la couche épaisse sur la couche mince, selon le procédé conforme à l'invention, la couche mince sert de germe de croissance pour une croissance quasi-monocristalline ou monocristalline de la couche épaisse. Ces conditions correspondent à une croissance quasi-épitaxiale ou épitaxiale de la couche épaisse sur la couche mince.

Le procédé selon l'invention comporte avantageusement mais facultativement les caractéristiques suivantes prises séparément ou en combinaison :
- il comprend une opération consistant à déposer la couche utile sur l'une, et sur l'autre des faces de la couche mince; cette couche utile étant, par exemple d'un matériau à grand gap, tel que le nitrure de gallium, le nitrure d'aluminium ou un autre de ces matériaux, par exemple un composé d'au moins deux éléments compris dans la liste comprenant l'aluminium, l'indium et le gallium ;
- au moins une couche utile est déposée avant la formation de la couche épaisse ;
- au moins une couche utile est déposée après la formation de la couche épaisse ;
- la couche utile et la couche épaisse sont déposées chacune sur une face différente de la couche mince ;
- la couche mince est constituée d'un matériau monocristallin ;
- la couche épaisse est formée par dépôt d'un matériau compris dans la liste composée des matériaux monocristallins, des matériaux polycristallins, des matériaux amorphes, des matériaux comportant plusieurs phases et des matériaux moins coûteux que celui constitutif de la couche mince ;
- il comporte une opération de formation d'une couche de liaison sur la couche mince, cette couche de liaison étant composée d'un matériau compris dans la liste comprenant les matériaux amorphes et les matériaux polycristallins et les matériaux métalliques tels que le tungstène ou le siliciure de tungstène ; étant entendu que ces propriétés peuvent être combinées (polycristallin et métallique par exemple) ; cette couche de liaison peut être formée, par exemple, avant que la couche mince ne soit détachée du substrat source ;
- il comprend une étape de transfert de la couche mince sur un support intermédiaire, avant la formation de la couche épaisse sur la couche mince ;
- il comprend une opération consistant à éliminer le support intermédiaire;
- l'élimination du support intermédiaire est réalisée en séparant la couche mince du support intermédiaire, afin notamment de recycler ce dernier;
- il comporte une opération de formation d'une couche de liaison sur le support intermédiaire avant le transfert de la couche mince dessus, cette couche de liaison étant composée d'un matériau compris dans la liste comprenant les matériaux amorphes, les matériaux polycristallins et les matériaux métalliques tels que le tungstène ou le siliciure de tungstène ; étant entendu que ces propriétés peuvent être combinées (polycristallin et métallique par exemple) ;
- la couche mince est constituée d'un matériau compris dans la liste comprenant le silicium, le carbure de silicium, le saphir, le diamant, le nitrure de gallium, le nitrure d'aluminium et une combinaison ou une superposition d'au moins deux de ces matériaux ;
- la couche épaisse est formée d'un matériau compris dans la liste comprenant le silicium, le carbure de silicium, le diamant, le saphir, le graphite, le nitrure de gallium, le nitrure d'aluminium, le nitrure de bore et une combinaison ou une superposition d'au moins deux de ces matériaux ;
- la couche mince est détachée du substrat source au niveau d'une zone de fragilisation ;
- la zone de fragilisation est réalisée en implantant, dans ce substrat source, des espèces atomiques au voisinage d'une profondeur déterminée.
- la couche mince est détachée du substrat source par élimination, par exemple par attaque chimique, d'une zone intercalée entre la couche mince et le reste du substrat source ;
- on optimise les conditions de dépôt de la couche épaisse afin que celle-ci corresponde à une qualité particulière comprise dans la liste comprenant les qualités monocristalline, polycristalline, isolante et conductrice, étant entendu que deux de ces qualités peuvent éventuellement être associées, comme les qualités monocristalline et conductrice.

Ci-dessus et dans la suite de ce document, on entend par implantation atomique, tout bombardement d'espèces atomiques ou ioniques, susceptibles d'introduire ces espèces dans un matériau, avec un maximum de concentration de ces espèces dans ce matériau, ce maximum étant situé à une profondeur déterminée par rapport à la surface bombardée. Les espèces atomiques ou ioniques sont introduites dans le matériau avec une énergie distribuée autour d'un maximum. L'implantation des espèces atomiques dans le matériau peut être réalisée grâce à un implanteur par faisceau d'ions, un implanteur par immersion dans un plasma, etc. Par espèces atomiques ou ioniques, on entend un atome sous sa forme ionique, neutre ou moléculaire, ou des molécules sous une forme ionique ou neutre, ou encore une combinaison de différents atomes ou molécules sous une forme ionique ou neutre.

D'autres aspects, buts et avantages de l'invention apparaîtront à la lecture de la description détaillée qui suit, l'invention sera également mieux comprise à l'aide des dessins annexés sur lesquels :
- la figure 1 représente schématiquement des étapes d'un exemple de mise en oeuvre d'un procédé qui n'est pas conforme à l'invention;
- la figure 2 représente schématiquement des étapes d'un autre exemple de mise en oeuvre d'un procédé qui n'est pas conforme à l'invention;
- la figure 3 représente schématiquement des étapes d'un exemple de mise en oeuvre du procédé conforme à l'invention ;
- la figure 4 représente schématiquement des étapes d'un autre exemple de mise en oeuvre du procédé conforme à l'invention ;
- la figure 5 représente schématiquement des étapes d'encore un autre exemple de mise en oeuvre du procédé conforme à l'invention;
- la figure 6 représente schématiquement des étapes d'encore un autre exemple de mise en oeuvre du procédé conforme à l'invention ;
- la figure 7 représente schématiquement en perspective, un support intermédiaire avec quatre couches minces, tel qu'il peut être utilisé selon une variante du procédé selon l'invention ; et
- les figures 8a et 8b représentent schématiquement en coupe, des exemples de substrats obtenus selon une variante du procédé.

Des procédés sont décrits ci-dessous de manière détaillée à l'aide de cinq modes particuliers.

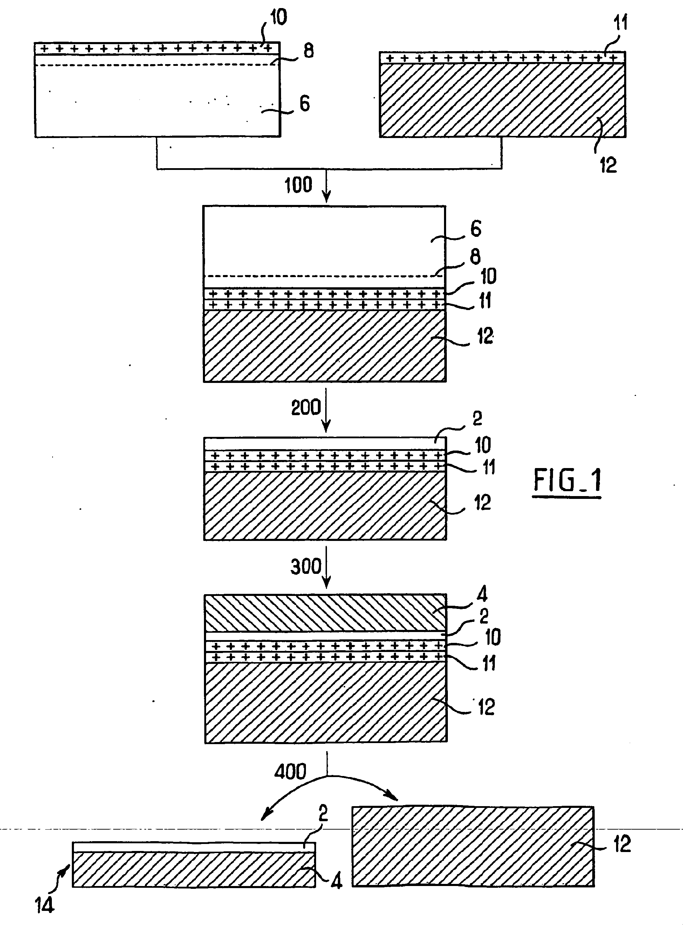

Selon le premier mode de mise en oeuvre, qui n'est pas conforme à l'invention et qui est illustré par la figure 1, on réalise un substrat final 14 comportant une couche mince 2 sur une couche épaisse 4 formant support mécanique de la couche mince en réalisant les étapes suivantes:
- formation d'une couche de matériau amorphe pour réaliser une couche de liaison 10 sur une surface d'un substrat source 6, destinée à subir une implantation d'espèces atomiques, formation d'une couche de matériau amorphe sur une surface d'un support intermédiaire 12 pour réaliser une autre couche de liaison 11,
- implantation d'espèces atomiques au niveau d'une profondeur déterminée du substrat source 6 pour former une zone de fragilisation 8,
- mise en contact 100 des couches de liaison 10 et 11,
- détachement 200 de la couche mince 2 à partir du substrat source 6 au niveau de la zone de fragilisation 8,
- dépôt 300 de la couche épaisse 4 sur la surface de la couche mince 2 correspondant à la zone de fragilisation 8, et
- élimination 400 des couches de liaison 10 et 11, pour séparer la couche mince 2 du support intermédiaire 12.

Les étapes de formation de la couche de liaison 10 et d'implantation d'espèces atomiques peuvent être réalisées dans l'ordre indiqué ci-dessus ou dans un autre.

Les étapes d'implantation d'espèces atomiques et de détachement 200 de la couche mince 2 sont décrites par exemple dans le brevet FR 2 681 472.

Les étapes de formation des couches de liaison 10 et 11 correspondent à la formation d'une couche de matériau amorphe selon l'une des méthodes connues par l'homme du métier.

Il faut noter que la couche mince 2 peut subir des étapes technologiques supplémentaires, avant d'être soumise au dépôt 300 de la couche épaisse 4, pour former des composants électroniques, en totalité ou en partie, ou faire l'objet de dépôts uniformes de films additionnels de nature épitaxiale ou non.

Le tableau ci-dessous regroupe des exemples de matériaux utilisables pour la mise en oeuvre du premier mode de mise en oeuvre décrit ci-dessus.

**Tableau 1**

| Couche mince 2 | Support intermédiaire 12 | Couche épaisse support 4 | Couches de liaison 10, 11 |
|---|---|---|---|
| SiC mono | SiC poly ou SiC mono | SiC poly ou AIN poly ou diamant ou SiC mono de moindre qualité que la couche mince | SiO₂ ou Si₃N₄ |
| GaN mono | SiC poly ou SiC mono ou saphir | SiC poly ou AIN poly ou GaN poly ou diamant ou SiC mono de moindre qualité que la couche mince | SiO₂ ou Si₃N₄ |
| Si mono {111}, {100}, etc. | Si poly ou Si mono ou SiC poly ou SiC mono | Si poly ou Si mono de moindre qualité que la couche mince | SiO₂ ou Si₃N₄ |

Dans le tableau ci-dessus, comme dans les suivants, le terme « mono » est utilisé pour « monocristallin » et le terme « poly » est utilisé pour « polycristallin ».

### EXEMPLE 1 :

Le premier exemple correspond à la première ligne du tableau 1.

Le premier mode de mise en oeuvre est particulièrement intéressant pour la formation d'un substrat comportant une couche mince 2 de carbure de silicium monocristallin sur une couche épaisse 4 de carbure de silicium polycristallin.

En effet, sous forme monocristalline, le carbure de silicium est peu disponible même dans des diamètres de substrats bien inférieurs à ceux obtenus actuellement pour le silicium monocristallin. Ceci est dû en particulier aux techniques de tirages de lingots qui sont bien plus complexes et onéreuses pour le carbure de silicium monocristallin que pour le silicium monocristallin, ainsi qu'à des étapes de mise en forme des substrats, plus délicates, plus longues et plus coûteuses, étant donné le rapport peu favorable entre la dureté et la fragilité du carbure de silicium.

Le procédé est ainsi particulièrement avantageux pour la réalisation de substrats avec des couches minces 2 de carbure de silicium puisqu'il permet de multiples prélèvements de couches minces 2, à partir d'un substrat source 6 et le report de chaque couche mince 2 prélevée, sur une couche épaisse 4 de faible coût.

De plus, le carbure de silicium trouve principalement des applications dans les dispositifs semi-conducteurs de forte puissance. Or pour ces applications, certaines spécifications très contraignantes limitent le choix possible des substrats supports pour le transfert de la couche mince 2 de carbure de silicium. En effet, ces applications requièrent dans certains cas de bonnes conductivités électrique et thermique du support. Le carbure de silicium polycristallin répond à ses exigences. Il est très proche pour certaines de ses propriétés, du carbure de silicium monocristallin: il permet un bon accord sur le coefficient de dilation thermique et il est compatible avec des traitements à des températures pouvant aller jusqu'à 1 600 ou 1 700° C (températures requises pour les reprises d'épitaxie du carbure de silicium et les recuits après implantation d'espèces atomiques).

En outre, l'utilisation du carbure de silicium polycristallin nécessite peu de modifications des technologies des utilisateurs habituels du carbure de silicium monocristallin.

Enfin, le carbure de silicium polycristallin présente de bonnes propriétés de résistance aux agressions chimiques.

Dans le cas de la réalisation d'une couche mince 2 de carbure de silicium monocristallin sur une couche épaisse 4 de carbure de silicium polycristallin, les couches de liaison 10 et 11 sont avantageusement formées d'oxyde de silicium.

La couche épaisse 4 peut être réalisée par dépôt chimique en phase vapeur (qui présente l'avantage majeur de pouvoir être effectué à des températures de dépôt relativement faibles, c'est à dire environ 1350°C pour le carbure de silicium), par épitaxie en phase vapeur (aussi connue par l'homme du métier sous l'acronyme VPE de l'expression anglo-saxonne « Vapor Phase Epitaxy » ou HVPE de l'expression anglo-saxonne « Hydride Vapor Phase Epitaxy »), par dépôt chimique en phase vapeur à haute température (aussi connue de l'homme du métier sous l'acronyme HTCVD de l'expression anglo-saxonne « High Temperature Chemical Vapor Déposition »), ou d'autres techniques équivalentes. On peut également utiliser, pour réaliser la couche épaisse 4, des techniques dérivées de celles généralement mises en oeuvre pour l'élaboration de lingots, telles que des techniques de sublimation ou d'autres techniques généralement utilisées dans les procédés de tirage de boules. L'utilisation de telles techniques n'est pas toujours optimale du point vue de la qualité du dépôt (basses températures, conditions non uniformes, vitesse de croissance élevée, etc.), mais elle peut l'être d'un point de vue économique.

La couche épaisse 4, pour des substrats de carbure de silicium de 50 mm de diamètre est avantageusement de trois cents microns. La couche épaisse 4 de carbure de silicium est avantageusement réalisée par dépôt chimique en phase vapeur à une vitesse de croissance de l'ordre de 100 microns par heure.

En outre, utilisant une surface correspondant au matériau monocristallin de la couche mince 2, pour le dépôt 300 de la couche épaisse 4, l'optimisation des paramètres de ce dépôt peut mener à l'élaboration d'un substrat support monocristallin. Dans ce cas donc, la couche mince 2 sert de germe de croissance pour l'élaboration d'une couche épaisse 4 monocristalline. Cette couche épaisse 4 monocristalline peut être, selon le degré d'optimisation des paramètres de dépôt et selon l'application visée, de mauvaise ou de moyenne qualité, mais le substrat en résultant pourra présenter néanmoins l'avantage d'être d'un coût relativement peu élevé. Mais, cette couche épaisse 4 monocristalline peut aussi être de bonne ou de très bonne qualité si l'application visée pour le substrat le nécessite. La croissance de la couche épaisse 4 peut également être poursuivie de manière à former un substrat avec une couche 4 très épaisse c'est-à-dire dépassant très largement les quelques centaines de micromètres, selon l'application. La couche épaisse 4, selon des variantes de l'exemple du mode de réalisation décrit ci-dessus, peut être réalisée, outre le carbure de silicium, en nitrure d'aluminium polycristallin, en diamant, ou en d'autres matériaux.

Le support intermédiaire 12 doit pouvoir supporter les conditions de croissance de la couche épaisse 4 de carbure de silicium et doit également pouvoir être supprimé. La voie choisie pour retirer le support intermédiaire 12 peut conditionner le choix du matériau constitutif de celui-ci. En effet, si l'on souhaite le sacrifier par gravure ou par enlèvement mécanique ou chimique, les étapes de gravures et d'enlèvement, ainsi que le support intermédiaire 12 lui-même, doivent être peu chers. Le nitrure d'aluminium, dans ce cas, est avantageusement utilisé. Le silicium également peu cher peut être choisi, mais il est plus difficilement compatible avec le dépôt du carbure de silicium de la couche épaisse 4. Par contre, si l'on enlève et on récupère le support intermédiaire 12, on peut utiliser des matériaux plus chers. Dans ce cas, on peut choisir du carbure de silicium polycristallin ou même éventuellement du carbure de silicium monocristallin puisque celui-ci n'est pas consommé et qu'il peut être réutilisé.

Avantageusement, on utilise un support intermédiaire 12 de carbure de silicium polycristallin recouvert d'une couche de liaison 11 d'oxyde de silicium.

L'utilisation de l'oxyde de silicium facilite la réalisation du prélèvement de la couche mince 2 sur le substrat source 6. En effet, le dépôt planarisé de l'oxyde de silicium permet de gommer les irrégularités de surface et de réaliser des étapes de polissage, de planarisation, de nettoyage, de préparation chimique et de collage oxyde de silicium sur oxyde de silicium, par des techniques connues et aisées à mettre en oeuvre.

L'oxyde de silicium des couches de liaison 10 et 11 peut également être remplacé par un autre matériau, par exemple le nitrure de silicium (Si₃N₄). Ce dernier permet de supporter des températures plus élevées que l'oxyde de silicium. Cet avantage est particulièrement intéressant dans le cadre de l'optimisation du dépôt de la couche épaisse 4 en vue de la formation d'une couche monocristalline ou polycristalline de bonne qualité ou encore lorsque l'on souhaite augmenter la vitesse du dépôt.

Ce premier exemple de mode de mise en oeuvre du procédé , comprend alors :
- la réalisation d'une structure constituée de l'empilement d'une couche mince 2 de carbure de silicium monocristallin, de deux couches de liaison 10 et 11 d'oxyde de silicium et d'un support intermédiaire 12 de carbure de silicium polycristallin ou monocristallin; cette structure est réalisée par un procédé de transfert de couches connu de l'homme du métier (par exemple, voir une mise en application d'un procédé Smart-Cut^{®} tel que celui décrit dans le brevet FR 2 681 472) ;
- dépôt 300 d'une couche épaisse support 4 en carbure de silicium, par exemple par dépôt chimique en phase vapeur à 1 350° C°, sur la surface libre de la couche mince 2 ;
- élimination 400 des couches de liaison 10 et 11 par gravure chimique en bain d'acide fluorhydrique et récupération du support intermédiaire 12 ; le carbure de silicium, sous forme monocristalline ou polycristalline, est inerte à l'acide fluorhydrique, tandis que l'oxyde de silicium se grave très .facilement par ce produit ; et
- polissage final grossier de la surface de la couche épaisse 4 de carbure de silicium polycristallin ; un polissage grossier est suffisant car il s'agit de la face arrière support du substrat final 14 ; dans le cas où le dépôt de la couche épaisse 4 est bien contrôlé, cette étape de polissage peut même être omise.

Si nécessaire, la forme géométrique du substrat final 14 est retouchée, par exemple pour remettre le substrat final 14 au diamètre voulu, remettre en forme des tombées de bords, éliminer des nodules en bord de substrat, etc.

Avantageusement également, la face avant de carbure de silicium monocristallin du substrat final 14, c'est à dire la surface libre de la couche mince 2, peut être protégée pendant les opérations de finition, notamment pendant celle optionnelle de polissage de la face arrière du substrat final 14. On peut noter que pendant les premières étapes du procédé , la couche mince 2 est naturellement protégée par le support intermédiaire 12.

Le substrat final 14 obtenu par le mode de mise en oeuvre du procédé décrit ci-dessus, présente une interface entre la couche mince 2 et la couche épaisse 4 très conductrice électriquement et thermiquement, puisque d'une part le dépôt direct du matériau de la couche épaisse 4 sur la couche mince 2 permet d'éviter, comme lorsque l'on utilise les procédés de l'art antérieur, les vides formés au moment du collage ; et que d'autre part contrairement aux techniques de l'art antérieur il peut ne pas être fait usage de couches intermédiaires d'oxyde de silicium ou autres, telles que celles généralement utilisées dans les techniques de collage. Le procédé permet également de s'affranchir des étapes de planarisation et de polissage du carbure de silicium qui présente une forte dureté et une grande inertie chimique. Ceci est particulièrement avantageux puisque ces problèmes de polissage sont exacerbés lorsque l'on utilise du carbure de silicium polycristallin, pour lequel les vitesses d'attaque, lors d'un polissage, varient de grains à grains ou encore entre grains et joints de grains et selon la qualité cristalline intrinsèque et volumique des grains.

On peut néanmoins noter que pour certaines applications, on pourra mettre en oeuvre le procédé selon l'invention pour former une couche épaisse 4, mais on choisira des matériaux ou des conditions de mise en oeuvre du procédé selon l'invention, permettant d'obtenir une interface faiblement conductrice électriquement ou thermiquement, par exemple en réalisant, entre la couche mince 2 et la couche épaisse 4, une couche intermédiaire d'un matériau isolant.

Le premier exemple de mode de mise en oeuvre du procédé , décrit ci-dessus peut comporter de nombreuses variantes ; en particulier, on pourra substituer aux matériaux cités ci-dessus, les autres exemples de matériau mentionnés dans la première ligne du tableau 1.

On pourra également substituer dans ce premier exemple de mise en oeuvre du procédé, l'opération d'élimination 400 des couches de liaison 10 et 11 par gravure chimique, par une opération de séparation du support intermédiaire 12 et de la couche mince 2, comportant une opération d'implantation d'espèces atomiques préalable (dans le support intermédiaire 12 par exemple) et/ou l'application de contraintes mécaniques. On pourra aussi faciliter l'opération d'élimination 400 des couches de liaison 10 et 11 et/ ou la séparation du support intermédiaire 12 et de la couche mince 2, par des techniques connues de l'homme du métier, telles que la formation de canaux dans les couches de liaison 10 et 11, etc.

Il est également possible de mettre en oeuvre le procédé décrit ci-dessus sans support intermédiaire 12. C'est en particulier le cas si la couche mince 2 transférée est suffisamment épaisse et réalisée dans un matériau suffisamment rigide. Ainsi, une couche mince 2 de carbure de silicium de quelques dizaines de microns d'épaisseur peut avoir une tenue mécanique suffisante.

On peut également noter que la polarité de la couche mince 2 de carbure de silicium prélevée sur le substrat source 6 peut être choisie en fonction de la polarité du substrat source 6 initial. La polarité d'un substrat de carbure de silicium correspond à la face Si ou à la face C et est un concept bien connu de l'homme du métier. Eventuellement, le prélèvement de la couche mince 2 sur le substrat source 6 peut faire l'objet d'un double transfert permettant de changer deux fois la polarité.

On peut également prévoir une opération consistant à former une couche intermédiaire, par exemple isolante, sur la couche mince 2, avant le dépôt de la couche épaisse 4. Cette couche intermédiaire est par exemple un oxyde fin (500 Å). On obtient alors par exemple un substrat de SiC sur isolant, constitué d'une couche mince 2 de SiC, sur une couche intermédiaire d'oxydé de silicium fin, elles-mêmes sur une couche épaisse 4 de silicium polycristallin par exemple.

Un deuxième exemple du premier mode de mise en oeuvre du procédé est décrit ci-dessous. Il correspond par exemple à la réalisation d'un substrat de nitrure de gallium pour des applications en optoélectronique notamment.

### EXEMPLE 2 :

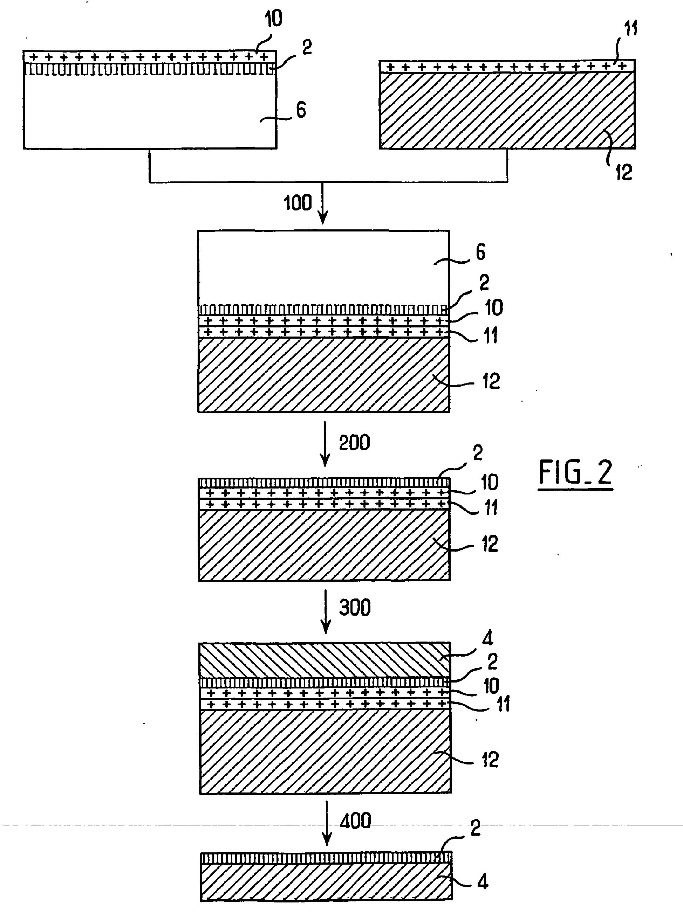

Selon ce deuxième exemple correspondant à la deuxième ligne du tableau 1, on réalise les étapes suivantes, illustrées par la figure 2:
- dépôt d'une couche mince 2 de nitrure de gallium monocristallin sur un substrat source 6 de carbure de silicium monocristallin, par dépôt chimique en phase vapeur d'organo-métalliques (connue de l'homme du métier sous l'acronyme « MOCVD », de l'expression anglo-saxonne « Metal Organic Chemical Vapor Déposition ») ou par épitaxie par jet moléculaire (connue de l'homme du métier sous l'acronyme « MBE », de l'expression anglo-saxonne « Molécular Beam Epitaxy ») ;
- dépôt d'une couche de liaison 10 en oxyde de silicium sur la couche mince 2 ;
- dépôt d'une couche de liaison 11 en oxyde de silicium sur un support intermédiaire 12 de carbure de silicium polycristallin;
- mise en contact 100 des deux couches de liaison 10 et 11, l'une avec l'autre, et collage de ces couches de liaison 10 et 11 entre elles ;
- détachement 200 de la couche mince 2 de nitrure de gallium du substrat source 6 au niveau de l'interface couche mince 2/substrat source 6 (par application de contraintes mécaniques par exemple) ou au niveau d'une zone de fragilisation réalisée par exemple par implantation d'espèces atomiques, dans le carbure de silicium monocristallin du substrat source 6 ou dans le nitrure de gallium de la couche mince 2 ;
- dépôt 300 d'une couche épaisse 4 de carbure de silicium polycristallin par dépôt chimique en phase vapeur, sur la surface libre de la couche mince 2; et
- séparation 400 par élimination des couches de liaison 10 et 11, par exemple en bain d'acide fluorhydrique ou par simple enlèvement de matière (en éliminant le support intermédiaire 12 et les couches de liaison 10 et 11, selon la technique connue de l'homme du métier sous la terminologie anglo-saxonne « Etch-back ») ou bien encore par fracture dans les couches de liaison 10 et 11, au niveau d'une zone préfragilisée ou non, ou selon toute autre technique connue de l'homme du métier et permettant de séparer deux parties d'un substrat, au niveau d'une zone prédéterminée, par action d'une contrainte mécanique, thermique, chimique, électrostatique, etc.

D'autres variantes de l'exemple 2 peuvent être envisagées. Ainsi on peut remplacer le dépôt 300 de carbure de silicium polycristallin par un dépôt chimique en phase vapeur de nitrure d'aluminium polycristallin ou de nitrure de gallium polycristallin ou par formation d'une couche de diamant, pour former la couche épaisse 4.

Selon une autre variante, on forme le nitrure de gallium polycristallin de la couche épaisse 4, par épitaxie en phase vapeur à haute pression.

Selon encore une autre variante, on remplace le carbure de silicium polycristallin du support intermédiaire 12 par du nitrure d'aluminium ou du saphir ; puis on réalise un dépôt 300 d'une couche épaisse 4 de nitrure d'aluminium polycristallin par dépôt chimique en phase vapeur avant l'élimination 400 des couches de liaison 10 et 11.

Selon encore une autre variante, on procède à l'une des variantes de l'exemple 2, mais on prélève une couche mince 2, qui comprend non seulement la couche de nitrure de gallium mais également une couche de carbure de silicium du substrat source 6 sous jacent. Ceci peut être réalisé, en formant une couche de fragilisation, à une certaine profondeur du substrat source 6, par exemple par implantation d'espèces atomiques. Dans ce cas, selon encore une autre variante, on élimine, outre les couches de liaison 10 et 11, la partie de la couche mince 2 en carbure de silicium, si l'on a fait un double transfert de la couche mince 2, c'est à dire avec un transfert avant son report sur le support intermédiaire 12.

Selon encore d'autres variantes, la couche de nitrure due gallium constitutive de la couche mince 2 est remplacée par du nitrure d'aluminium ou un autre matériau ou encore un empilement de ces différents matériaux, éventuellement avec d'autres composés intermédiaires.

Un troisième exemple du premier mode de mise en oeuvre du procédé est décrit ci-dessous.

### EXEMPLE 3 :

Cet exemple correspond à la réalisation de substrats de silicium monocristallin de grand diamètre. Ces substrats sont chers car difficiles à réaliser. Comme pour les substrat de carbure de silicium monocristallin, il est avantageux de réaliser une couche mince de matériau monocristallin sur un support de moindre qualité, par exemple en matériau polycristallin, amorphe ou autre. Si l'on procède par collage direct de la couche mince sur un support, on rencontre des difficultés de polissage, de planarisation, de physico-chimie de l'interface de collage, de dégazage, etc. Le procédé permet avantageusement d'éviter ces difficultés, le support étant réalisé par dépôt direct d'une couche épaisse 4 formant support sur une face de la couche mince 2.

Le procédé permet en effet, comme expliqué plus haut, de réaliser une interface de très bonne qualité.

Avantageusement, on procède à un dopage, variant éventuellement en fonction de l'épaisseur, en cours de dépôt de la couche épaisse 4, pour favoriser la transparence électrique et thermique de cette interface.

Selon ce troisième exemple correspondant à la troisième ligne du tableau 1, on procède aux étapes suivantes :
- réalisation d'une couche mince 2 de silicium monocristallin sur isolant (couche de liaison 10 et/ou 11), sur un support intermédiaire 12 ;
- formation 300 d'une couche épaisse 4 d'au moins 725 µm de silicium polycristallin sur la couche mince 2 ;
- séparation et récupération 400 du support intermédiaire 12,
- traitement physico-chimique par gravure sélective silicium / oxyde de silicium (par exemple par l'acide fluorhydrique) ou/et opérations d'enlèvement mécanique, pour retrouver une bonne qualité de la zone superficielle du silicium de la couche mince 2 ; et
- opérations de mise en forme (polissage, rodage, façonnage des bords, traitement chimique du substrat final 14 obtenu pour le rendre conforme aux normes (SEMI ou JEIDA par exemple) sur la planéité, l'épaisseur, les tombées de bord, etc.

L'étape de réalisation d'un substrat de silicium sur isolant peut être effectuée, comme déjà décrit plus haut, en procédant à une implantation d'espèces atomiques au niveau d'une zone de fragilisation 8 dans un substrat source 6 de silicium et à la formation d'une couche de liaison 10 d'oxyde de silicium, sur le substrat source 6, ainsi qu'à la formation d'une autre couche de liaison 11 d'oxyde de silicium sur un support intermédiaire 12 de silicium polycristallin ou même monocristallin, puis à la mise en contact 100 et au collage des couches de liaison 10 et 11, avant de procéder au détachement de la couche mince 2 du substrat source 6.

Cette étape de réalisation d'un substrat de silicium sur isolant peut être effectuée, par exemple, par une technique Smart-Cut^{®} (voir le brevet FR 2 981 472 par exemple).

Ce substrat de silicium sur isolant doit être démonté, après formation de la couche épaisse 4 ; ceci peut être effectué par n'importe quelle technique connue permettant le détachement de la couche mince 2 de silicium du substrat source 6. Une telle technique peut être une technique telle que celle connue de l'homme du métier sous la terminologie anglo-saxonne « lift-off », par laquelle on élimine l'oxyde de silicium enterré (les couches de liaison 10 et 11 par exemple). Une telle technique peut également faire intervenir l'application de contraintes mécaniques. A la place de la technique de lift-off mentionnée ci-dessus, on peut aussi utiliser des contraintes mécaniques thermiques, électrostatiques, etc., pour provoquer un détachement de deux parties situées de part et d'autre d'une interface de collage, d'une interface d'épitaxie, une zone poreuse, d'une zone préfragilisée, etc.

La séparation du support intermédiaire 12 peut être réalisée au niveau de la première interface de collage, ou de l'une quelconque des interfaces de collage entre les couches de liaison 10 et 11 et le support intermédiaire 12, ou si l'on a procédé à une implantation supplémentaire d'espèces atomiques (d'hydrogène par exemple), dans les couches de liaison 10 et 11, dans la couche mince 2 ou dans le support intermédiaire 12 au niveau de la zone fragilisée par cette implantation.

On notera que les opérations de mise en forme mentionnées plus haut peuvent être également, en partie ou en totalité, réalisées avant la séparation de la couche mince 2 du support intermédiaire 12.

On notera également qu'avant le dépôt 300 de la couche épaisse 4, un isolant (oxyde, nitrure, diamant, etc.) peut être formé sur la couché mince 2, de sorte que le substrat final 14 soit une structure de silicium sur isolant.

Selon une variante de l'exemple présenté ci-dessus, on forme une couche épaisse 4 de diamant sur la couche mince 2. Le substrat final 14 en résultant est particulièrement avantageux lorsqu'il est utile d'avoir une bonne évacuation de la chaleur générée au niveau de la couche mince 2.

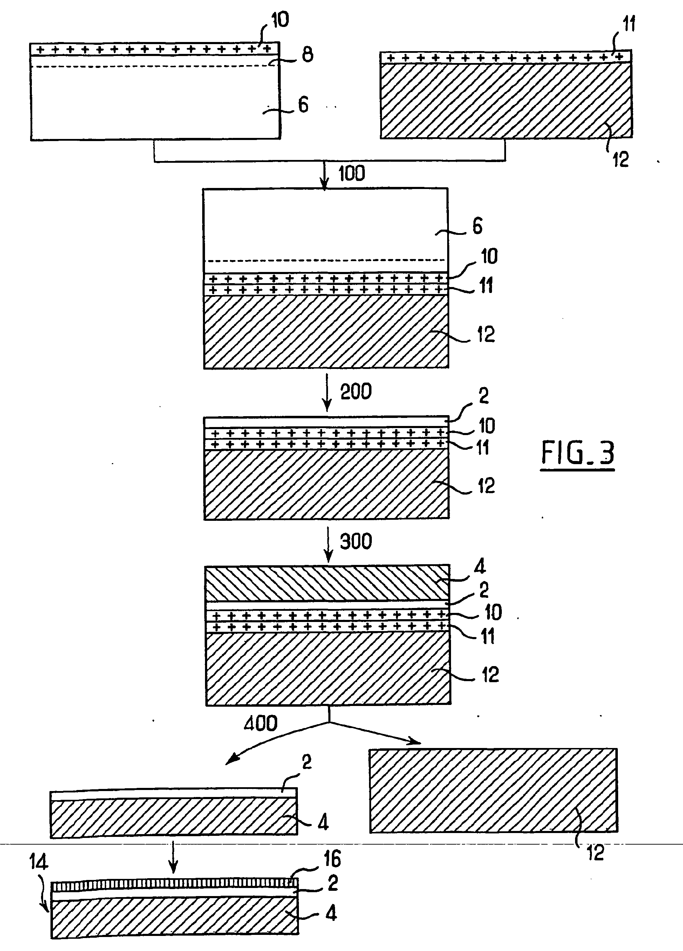

Selon le deuxième mode de mise en oeuvre du procédé lequel deuxième mode est conforme à l'invention et est illustré par la figure 3, on réalise une couche mince 2 sur une couche épaisse 4 de la manière indiquée ci-dessus dans le cadre du premier exemple de mode de mise en oeuvre de procédé selon l'invention, puis on dépose une couche utile 16 sur la face libre de la couche mince 2.

Le tableau 2 ci-dessus regroupe six exemples de ce deuxième mode de mise en oeuvre du procédé qui est le premier mode selon l'invention, dans le cadre de la réalisation de substrats présentant un intérêt dans les domaines de l'électronique, l'optique ou l'optoélectronique.

**Tableau 2**

| Couche utile 16 | Couche mince 2 | Support intermédiaire 12 | Couche épaisse 4 | Couches de liaison 10, 11 |
|---|---|---|---|---|
| GaN ou AlN ou AlGaN ou GalnN ou autres | SiC mono | SiC poly ou SiC mono (notamment si recyclé) | SiC poly ou diamant ou nitrure de bore | SiO₂ ou Si₃N₄ |
| GaN ou AIN ou AlGaN ou GalnN ou autres | Si {111} | SiC poly ou SiC mono (notamment si recyclé) | SiC poly ou diamant ou nitrure de bore | SiO₂ ou Si₃N₄ |
| GaN ou AIN ou AlGaN ou GalnN ou autres | Saphir | SiC poly ou SiC mono (notamment si recyclé) | SiC poly ou diamant ou nitrure de bore | SiO₂ ou Si₃N₄ |
| GaN ou AlN ou AlGaN ou GalnN ou autres | SiC mono ou Si {111} ou Saphir | SiC poly ou SiC mono (notamment si recyclé) | AlN poly ou diamant ou nitrure de bore | SiO₂ ou Si₃N₄ |
| GaN ou AIN ou AlGaN ou GalnN ou autres | SiC mono ou Si {111} ou Saphir | SiC poly ou SiC mono (notamment si recyclé) | GaN poly ou diamant ou nitrure de bore | SiO₂ ou Si₃N₄ |
| GaN ou AlN ou AlGaN ou autres | SiC mono ou Si {111} ou Saphir | AlN poly | AlN ou GaN ou SiC poly ou diamant ou nitrure de bore | SiO₂ ou Si₃N₄ |

### EXEMPLE 4 :

Selon cet exemple (1^{ère} ligne du tableau 2), on réalise une couche mince de 2 de carbure de silicium monocristallin sur un support intermédiaire 12 de carbure de silicium polycristallin avec des couches de liaison 10 et 11 d'oxyde de silicium, entre les deux. Puis on dépose une couche épaisse 4 de carbure de silicium polycristallin par dépôt chimique en phase vapeur. La structure ainsi obtenue subit ensuite un traitement apte à produire un détachement de la structure constituée de la couche mince 2 sur la couche épaisse 4 du support intermédiaire. Ce traitement consiste par exemple en une gravure dans l'acide fluorhydrique avec ou sans contrainte mécanique, des couches de liaison 10 et 11, ou par un simple enlèvement de la matière du support intermédiaire 12 et éventuellement des couches de liaison 10 et 11. Enfin, on réalise sur la face libre du carbure de silicium monocristallin de la couche mince 2 un dépôt d'une couche utile 16 de nitrure de gallium par MOCVD. La couche utile 16 de nitrure de gallium est particulièrement intéressante pour les applications en optoélectronique.

### EXEMPLE 5 :

Selon cet exemple (deuxième ligne du tableau ci-dessus), on réalise de la manière décrite précédemment une structure comportant une couche mince 2 de silicium {111} sur un support intermédiaire 12 de carbure de silicium polycristallin, avec une couche d'oxyde de silicium entre les deux. On dépose sur la couche mince 2 de silicium {111}, une couche épaisse 4 de carbure de silicium polycristallin par dépôt chimique en phase vapeur. La structure ainsi obtenue subit alors un traitement dans un bain d'acide fluorhydrique avec ou sans contraintes mécaniques, ou tout autre traitement apte à séparer la couche mince 2 et la couche épaisse 4, du support intermédiaire 12. On réalise ensuite un dépôt de nitrure de gallium monocristallin par MOCVD sur la surface libre du silicium {111} qui est un matériau connu pour permettre une bonne épitaxie du nitrure de gallium. De préférence, l'épaisseur du silicium {111} est limitée avantageusement à une épaisseur inférieure à 1000 Å, afin qu'elle puisse s'adapter sans casser, à la dilatation thermique susceptible de se produire lors des différentes opérations mentionnées ci-dessus.

### EXEMPLE 6:

Selon cet exemple (troisième ligne du tableau ci-dessus) on réalise une couche mince 2 de saphir sur un support intermédiaire 12 de carbure de silicium polycristallin, avec des couches de liaison 10 et 11 d'oxyde de silicium entre les deux, puis on procède au dépôt 300 d'une couche épaisse 4 de carbure de silicium sur la couche mince 2. Les couches de liaison 10 et 11 sont éliminées pour récupérer le support intermédiaire 12. Enfin, une couche utile 16 de nitrure de gallium est déposée sur le saphir. Le saphir est aussi un matériau connu pour permettre une bonne épitaxie du nitrure de gallium.

### EXEMPLE 7 :

Selon ce septième exemple (quatrième ligne du tableau ci-dessus) on réalise l'une des structures décrites dans l'un des trois exemples précédents mais dans laquelle on remplace la couche épaisse 4 de carbure de silicium polycristallin par du nitrure d'aluminium polycristallin.

### EXEMPLE 8 :

Selon cet exemple (cinquième ligne du tableau ci-dessus) on réalise une structure telle que celle décrite dans l'un des exemples 4 à 6 ci-dessus, mais dans laquelle on remplace la couche épaisse 4 de carbure de silicium polycristallin par du nitrure de gallium polycristallin déposé par HVPE.

### EXEMPLE 9:

Selon cet exemple (sixième ligne du tableau ci-dessus) on réalise une structure telle que celle décrite dans l'un des cinq exemples précédents, mais dans laquelle on remplace le carbure de silicium polycristallin des supports intermédiaires 12 par du nitrure d'aluminium polycristallin.

Dans les six derniers exemples ci-dessus le carbure de silicium monocristallin, le silicium {111} ou le saphir servent de substrat d'épitaxie pour le nitrure de gallium. Le carbure de silicium a pour avantage d'avoir un coefficient de dilatation thermique peu différent de celui du nitrure de gallium.

On notera que les propriétés en épaisseur de la couche épaisse 4 peuvent être importantes, par exemple lorsque l'on souhaite prendre un contact électrique en face arrière du substrat final 14 ou lorsque l'évacuation de la chaleur générée par les composants réalisés sur la couche utile 16 est déterminante, ou encore lorsque l'on souhaite extraire et maîtriser la lumière émise par une diode ou un laser réalisé sur la couche utile 16.

On peut noter que si l'épaisseur de la couche mince 2 et la raideur du matériau qui la constitue sont suffisantes, des structures équivalentes à celles décrites ci-dessus peuvent être réalisées sans support intermédiaire 12.

De nombreuses variantes sont encore possibles pour ce deuxième exemple de mode de mise en oeuvre du procédé selon l'invention. Ainsi l'étape de formation de la couche épaisse 4 de SiC polycristallin, de nitrure d'aluminium ou de nitrure de gallium, peut être remplacée par une étape de formation d'une couche épaisse 4 de diamant ou de nitrure de bore.

Selon d'autres variantes, on change la nature du support intermédiaire 12. Ainsi, on utilise du carbure de silicium monocristallin (notamment lorsqu'on recycle ce dernier), à la place du carbure de silicium polycristallin ou du nitrure d'aluminium polycristallin.

De même, ces exemples sont transposables aux cas où l'on forme conformément à l'invention, une couche utile 16 de nitrure d'aluminium, d'un alliage d'aluminium et de gallium, ou d'un alliage de gallium et d'indium, etc., à la place de la couche utile 16 de nitrure de gallium, comme cela a été décrit ci-dessus. La couche utile 16 de nitrure de gallium peut également être une structure multicouche empilant des couches de type nitrure de gallium, nitrure d'aluminium, etc., éventuellement avec des dopages de natures différentes, etc.

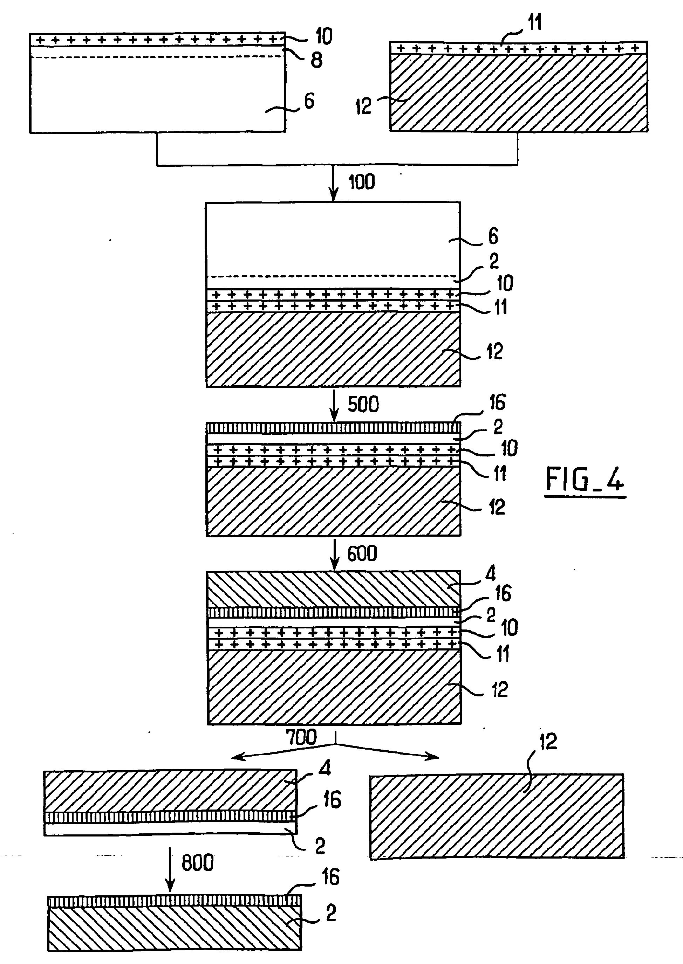

Selon le troisième exemple de mode de mise en oeuvre du procédé qui est le deuxième mode selon l'invention, illustré par la figure 4, on réalise une structure dans laquelle la couche épaisse 4 est, contrairement à ce qui a été décrit en relation avec le deuxième mode de mise en oeuvre du procédé, directement déposée sur la couche utile 16, elle-même déposée directement sur la couche mince 2, après que cette dernière ait été séparée du substrat source 6.

Le troisième mode de mise en oeuvre du procédé est décrit ci-dessous à l'aide de trois exemples.

Les matériaux utilisés dans le cadre de ces trois exemples sont regroupés dans le tableau 3.

**Tableau 3**

| Couche utile 16 | Couche mince 2 | Support intermédiaire 12 | Couche épaisse 4 | Couches de liaison 10,11 |
|---|---|---|---|---|
| GaN ou AIN ou AlGaN ou GalnN ou autres | SiC mono ou Si {111} ou Saphir | SiC poly (ou mono) ou AlN poly ou diamant ou autres | AIN ou GaN ou SiC poly ou autres | SiO₂ ou Si₃N₄ |
| GaN ou AlN ou AlGaN ou GalnN ou autres | SiC mono ou Si {111} ou Saphir + Gravure | SiC poly (ou mono) ou AlN poly ou diamant ou autres | AlN ou GaN ou SiC poly ou autres | SiO₂ ou Si₃N₄ |
| + Gravure d'une partie du GaN ou autre | SiC mono ou Si {111} ou Saphir + Gravure | SiC poly (ou mono) ou AlN poly ou diamant ou autres | AlN ou GaN ou SiC poly ou autres | SiO₂ ou Si₃N₄ |

### EXEMPLE 10 :

Selon cet exemple (première ligne du tableau 3), on réalise une structure comprenant une couche mince 2 de carbure de silicium monocristallin sur un support intermédiaire 12 de carbure de silicium polycristallin, avec des couches de liaison 10 et 11 d'oxyde de silicium entre les deux, de la manière décrite ci-dessus pour les premiers et deuxièmes exemples de mode de mise en oeuvre du procédé. On réalise ensuite, sur la surface libre de la couche mince 2 de carbure de silicium, une couche utile 16 de nitrure de gallium monocristallin par MOCVD. Une couche épaisse 4 de carbure de silicium polycristallin est alors déposée par dépôt chimique en phase vapeur sur la couche utile 16. La structure ainsi obtenue subit ensuite un traitement 700 apte à séparer la structure constituée de la couche mince 2, de la couche utile 16 et de la couche épaisse 4, du support intermédiaire 12. Ce traitement consiste, par exemple en une gravure dans l'acide fluorhydrique avec ou sans contrainte mécanique, ou par un simple enlèvement de matière. On obtient ainsi d'une part une structure constituée de l'empilement successif d'une couche épaisse 4 servant de support à une couche utile 16 de nitrure de gallium, elle-même recouverte d'une couche mince 2 de carbure de silicium monocristallin et d'autre part le support intermédiaire 12 prêt à être recyclé.

Ici, et contrairement au deuxième mode de mise en oeuvre du procédé exposé ci-dessus, le nitrure de gallium monocristallin est déposé avant la formation de la couche épaisse 4.

### EXEMPLE 11 :

Selon un autre exemple de ce troisième mode de mise en oeuvre du procédé, on réalise la structure de l'exemple 10, puis la couche mince 2 de carbure de silicium monocristallin est retirée, par exemple par une gravure 800 dans un plasma (deuxième ligne du tableau 3).

### EXEMPLE 12 :

Selon encore un autre exemple de ce troisième mode de misé en oeuvre du procédé (troisième ligne du tableau 3), on réalise une structure telle que celle de l'exemple 11, à la différence que l'on retire non seulement la couche 2 de carbure de silicium monocristallin mais en plus une partie de la couche utile de nitrure de gallium.

On peut noter que la couche mince 2 de carbure de silicium monocristallin ou la couche utile 16 de nitrure de gallium monocristallin peut subir quelques étapes technologiques supplémentaires avant d'être soumise au dépôt de la couche épaisse 4, ces étapes visant à réaliser des composants électroniques, en totalité ou en partie, ou faire l'objet de dépôts uniformes de films additionnels de nature épitaxiale ou non.

Il faut noter également que la polarité de la couche mince 2 de carbure de silicium monocristallin et celle de la couche utile 16 de nitrure de gallium peuvent être déterminées par le choix de la polarité du substrat source 6 initial. Eventuellement, le procédé selon l'invention comprend au moins un double transfert permettant de changer deux fois la polarité.

De même, ces exemples sont transposables aux cas où l'on forme conformément à l'invention, une couche utile 16 de nitrure d'aluminium, d'un alliage d'aluminium et de gallium, ou d'un alliage de gallium et d'indium, etc., à la place de la couche utile 16 de nitrure de gallium, comme cela a été décrit ci-dessus. La couche utile 16 de nitrure de gallium peut également être une structure multicouche empilant des couches de type nitrure de gallium, nitrure d'aluminium, etc., éventuellement avec des dopages de natures différentes, etc.

Selon d'autres variantes, on change la nature du support intermédiaire 12. Ainsi, on utilise du carbure de silicium monocristallin (notamment lorsqu'on recycle ce dernier), du diamant ou un autre matériau, à la place du carbure de silicium polycristallin ou du nitrure d'aluminium.

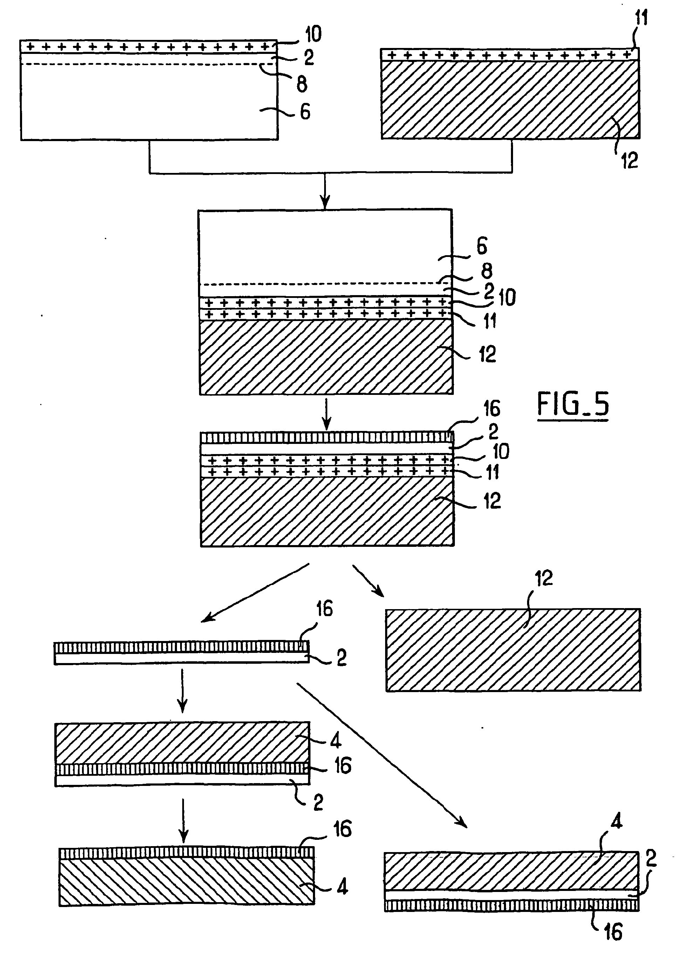

Selon un quatrième mode de mise en oeuvre du procédé qui est le troisième mode selon l'invention, et qui est illustré par la figure 5, on réalise le dépôt d'une couche utile 16 sur une couche mince 2, elle-même sur un support intermédiaire 12 avant de séparer du support intermédiaire 12, la structure constituée de la couche mince 2 et de la couche utile 16 et de procéder au dépôt de la couche épaisse 4 sur la couche mince 2 ou sur la couche utile 16, c'est à dire d'un côté ou de l'autre de la structure constituée par la couche mince 2 et la couche utile 16.

Ce qua trième mode de mise en oeuvre du procédé est illustré par deux exemples.

### EXEMPLE 13 :

Selon cet exemple, on réalise les étapes suivantes:
- formation, d'une part, d'une structure constituée d'une couche mince 2 de carbure de silicium monocristallin sur un substrat source 6, avec une zone de fragilisation 8, et d'autre part, d'un support intermédiaire 12, avec des couches de liaison 10 et 11 entre les deux, par exemple conformément à ce qui a été décrit ci-dessus, dans le cadre du premier mode de mise en oeuvre ;
- détachement, au niveau d'une zone de fragilisation 8 (par exemple obtenue par implantation dans le substrat source 6 préalablement à la mise en contact avec le support intermédiaire 12), de la couche mince 2 et du substrat source 6 ;
- dépôt d'une couche utile 16 de nitrure de gallium monocristallin, sur la surface libre de la couche mince 2 de carbure de silicium ;
- détachement de l'ensemble constitué da la couche mince 2 et de la couche utile 16, du support intermédiaire 12 (par exemple, par traitement dans un bain d'acide fluorhydrique) ; et
- dépôt d'une couche épaisse 4 de carbure de silicium polycristallin sur la surface libre de la couche utile 16.

### EXEMPLE 14 :

Selon cet exemple, on procède comme pour l'exemple précèdent mais on remplace le dépôt de la couche épaisse 4 sur la couche utile 16 par un dépôt de la couche épaisse 4 sur la couche mince 2.

Comme déjà mentionné plus haut si l'épaisseur, et la rigidité des couches mince 2 et utile 16 le permettent, on peut envisager d'exploiter les modes de mise en oeuvre décrits ci-dessus sans support intermédiaire 12 à aucun moment du procédé, ou sans support intermédiaire 12, pour le dépôt de la couche épaisse 4, mais, dans ce dernier cas, avec un support temporaire qui sert de raidisseur pour l'étape de séparation de la couche mince 2 du substrat source 6, ce support temporaire étant ôté avant le dépôt de la couche épaisse 4.

Le cinquième mode de mise en oeuvre correspond aux cas de procédés au cours desquels on utilise ni support intermédiaire 12, ni support temporaire au sens indiqué ci-dessus.

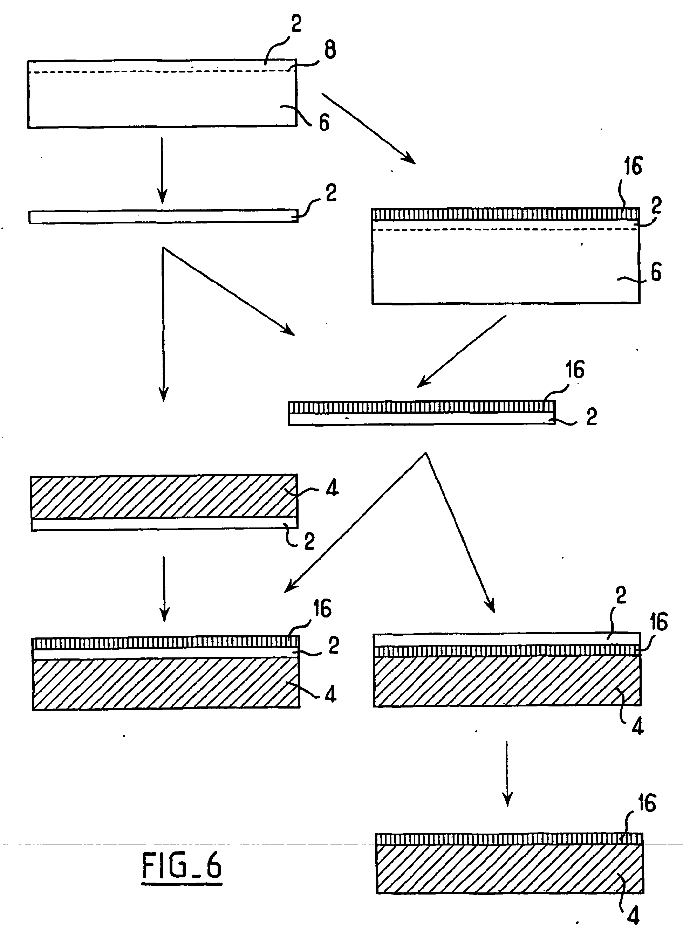

Quelques exemples de ce mode de mise en oeuvre du procédé selon l'invention, sans support intermédiaire 12 sont illustrés sur la figure 6.

Ainsi, partant d'un substrat source 6 dans lequel a été produite une zone de fragilisation 8 (par exemple par implantation d'espèces atomiques), on peut soit séparer la couche mince 2 directement, soit déposer une couche utile 16 avant de séparer la couche mince 2 de son substrat source 6, au niveau de la zone de fragilisation 8.

Dans le premier cas, on procède alors au dépôt de la couche épaisse 4 sur la couche utile 2 (on retrouve alors par exemple le substrat final 14 de l'exemple 1). Eventuellement, on peut poursuivre cette voie par le dépôt d'une couche utile 16 sur la face de la couche mince 2, opposée à celle ayant reçue la couche épaisse 4 (on retrouve alors par exemple le substrat final 14 de l'exemple 4).

Dans le deuxième cas, on procède au dépôt de la couche épaisse 4 du coté de la couche mince 2 (on retrouve alors ainsi le substrat final 14 de l'exemple 4) ou du coté de la couche utile 16 (on retrouve alors le substrat final 14 de l'exemple 10). De manière facultative, on peut alors procéder, comme décrit en relation avec la figure 4 (voir étape 800), au retrait de la couche mince 2 (on retrouve alors par exemple le substrat final de l'exemple 11).

De nombreuses variantes aux modes de mise en oeuvre décrits ci-dessus peuvent encore être envisagées.

On pourra par exemple combiner ensemble des opérations décrites dans des exemples différents de modes de mise en oeuvre du procédé .

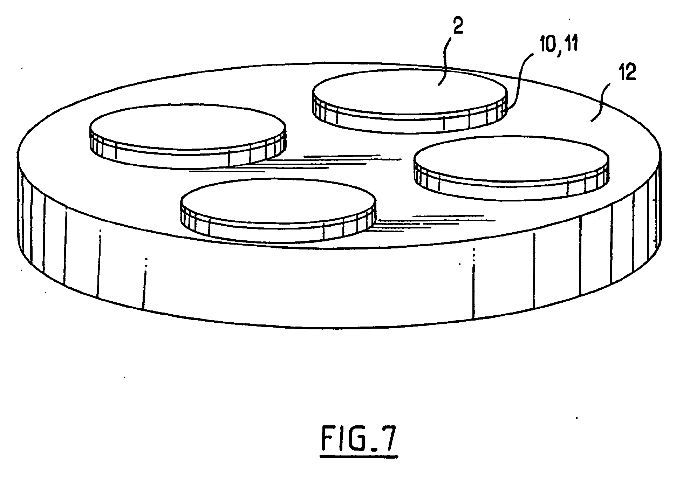

Ainsi, comme représenté sur la figure 7, une variante consiste à traiter par lots les couches minces 2 obtenues avant dépôt dé la couche épaisse 4. Dans ce cas, ces couches minces 2 sont fixées sur un support intermédiaire 12 unique de grande dimension.

La forme de ce support intermédiaire 12 unique peut être quelconque (circulaire, rectangulaire, etc.).

Dans ce cas, les couches minces 2 peuvent être identiques ou différentes. Chacune de ces couches minces 2 peut faire l'objet d'une opération séparée de détachement de la couche mince 2 du support intermédiaire 12. Le support intermédiaire 12 unique est par exemple une plaque de carbure de silicium polycristallin recouverte d'un oxyde de silicium.

Après dépôt de la couche épaisse 4, l'ensemble du support intermédiaire 12 unique et des ensembles couche mince 2 / couche épaisse 4 subit un lift-off en bain d'acide fluorhydrique. Chaque support intermédiaire 12 unique est recyclé.

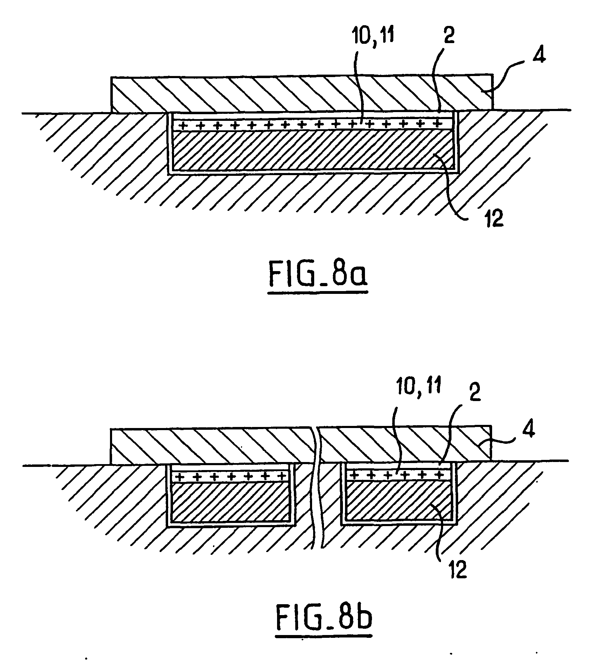

Selon encore une autre variante des modes de mise en oeuvre décrits ci-dessus, on dépose une couche épaisse 4 sur une surface plus importante que celle correspondant aux faces principales de la couche mince 2. Cette variante est illustrée par la figure 8.

Selon cette variante, on forme une structure constituée d'une couche mince 2, sur un support intermédiaire 12, avec des couches de liaison 10 et 11 entre les deux, telle que celles réalisées selon le premier mode de mise en oeuvre exposé ci-dessus. Cette structure est ensuite placée dans un porte-échantillon 20 de manière à ce que la surface libre de la couche mince 2 affleure à la surface du porte échantillon 20 (voir figure 8a).Une couche épaisse 4 est alors formée sur cette surface libre avec un dépassement sur le porte échantillon 20.

Le substrat aussi formé peut éventuellement subir un traitement apte à supprimer les bords qui dépassent de la couche mince 2. En effet, les bords d'une couche déposée présentent généralement des irrégularités, des défauts, des bourrelets, etc. La présente variante permet d'éliminer ces bords.

Cette variante est aussi avantageuse pour former un substrat ayant un diamètre supérieur à celui de la couche mince 2 et qui est adapté à une ligne de traitement de substrat d'un diamètre donné, alors que la couche mince 2 ne peut être formée directement à ce diamètre.

Cette variante est aussi avantageuse lorsque, formant une couche épaisse 4 unique sur plusieurs couches minces 2, on réalise un support unique pour plusieurs couches minces 2 et/ou couches utiles 16 (voir figure 8b). Cette variante peut aussi être mise en oeuvre en formant une couche épaisse 4, sur chaque ensemble constitué d'un support intermédiaire 12 et d'une couche mince 2 et placé sur un porte-échantillon plan. La couche épaisse 4 retombe alors sur les bords de la couche mince 2.

On a mentionné plus haut une variante du procédé consistant à optimiser les paramètres de dépôt de la couche épaisse 4 afin de réaliser une couche épaisse 4 monocristalline.

Même si la qualité d'une telle couche épaisse 4 monocristalline n'est pas optimale, elle peut s'avérer suffisante pour de nombreuses applications, pour lesquelles une très bonne qualité cristalline n'est requise que pour la couche superficielle 2 ou 16.

De telles variantes du procédé sont particulièrement intéressantes lorsque la croissance de lingots n'existe pas (cas du nitrure de gallium) ou lorsqu'elle est onéreuse (cas du carbure de silicium monocristallin).

On peut réaliser des dépôts chimiques en phase vapeur d'une couche épaisse 4 de carbure de silicium, sur une couche superficielle 2 ou 16 servant de germe de croissance pour la couche épaisse 4, avec des vitesses de croissance très importantes (de quelques dizaines à quelques centaines de microns par heure).

On notera que dans les techniques de l'art antérieur on fait souvent croire des couches minces 2 sur un support par épitaxie. Dans ce cas le substrat doit être de très bonne qualité pour que la couche mince épitaxiée dessus le soit également, c'est à dire pour éviter que les défauts ne soient transférés.

Dans le procédé, le support, c'est à dire la couche épaisse 4, peut être réalisé à moindre coût, puisqu'il s'agit d'un support dont la qualité sera souvent moins importante, d'autant plus qu'elle ne sert pas nécessairement à une reprise d'épitaxie.

Selon d'autres variantes, ce qui a été exposé ci-dessus est transposé à d'autres semiconducteurs tels que le phosphure d'indium et l'arséniure de gallium.

Selon encore d'autres variantes, on réalise une couche intermédiaire, par exemple isolante, entre la couche mince 2, et/ou la couche utile 16, et la couche épaisse 4 ou encore entre la couche mince 2 et la couche utile 16. Cette couche intermédiaire est par exemple en diamant, un oxyde fin (500 Å), etc.

## Revendications

1. Procédé de fabrication d'un substrat comprenant une couche mince portée par une couche constituant un support mécanique, notamment pour l'optique, l'électronique ou l'optoélectronique, le procédé comprenant les étapes suivantes:
- détacher d'un substrat source (6) une couche d'un matériau pour former la couche mince (2), puis
- déposer progressivement sur la couche mince (2) un matériau en une couche épaisse (4) pour former la couche constituant le support mécanique,
ce procédé étant **caractérisé en ce qu'**il comprend une opération consistant à déposer une couche utile (16) en matériau semi-conducteur sur l'une des faces de la couche mince (2).

2. Procédé selon la revendication 1, **caractérisé en ce que** ladite couche utile (16) est réalisée dans un matériau cristallin.

3. Procédé selon la revendication 1 ou 2, **caractérisé en ce que** ladite couche utile (16) est déposée après le détachement de la couche mince (2), du substrat source (6).

4. Procédé selon l'une des revendications précédentes, **caractérisé par le fait que** la couche épaisse (4) est déposée, sur la couche mince, par une technique comprise dans la liste comprenant les dépôts chimiques en phase vapeur, les dépôts en phase liquide, les dépôts par jet moléculaire.

5. Procédé selon l'une des revendications précédentes **caractérisé par le fait qu'**il comprend une opération consistant à déposer la couche utile (16) sur l'une et sur l'autre face de la couche mince (2).

6. Procédé selon l'une des revendications précédentes, **caractérisé par le fait que** la couche utile (16) est déposée avant la formation de la couche épaisse (4).

7. Procédé selon l'une des revendications précédentes, **caractérisé par le fait que** la couche utile (16) est déposée après la formation de la couche épaisse (4).

8. Procédé selon l'une des revendications précédentes, **caractérisé par le fait que** la couche utile (16) est constituée d'un matériau à grand gap, compris dans la liste comprenant le nitrure de gallium, le nitrure d'aluminium, le phosphure d'indium et l'arseniure de gallium et les composés d'au moins deux éléments compris dans la liste comprenant l'aluminium, l'indium et le gallium.

9. Procédé selon l'une des revendications précédentes, **caractérisé par le fait que** la couche utile (16) et la couche épaisse (4) sont déposées chacune sur une face différente de la couche mince (2).

10. Procédé selon l'une des revendications précédentes, **caractérisé par le fait que** la couche mince (2) est constituée d'un matériau monocristallin.

11. Procédé selon l'une des revendications précédentes, **caractérisé par le fait que** la couche épaisse (4) est formée par dépôt d'un matériau compris dans la liste composée des matériaux monocristallins, des matériaux polycristallins, des matériaux amorphes, des matériaux comportant plusieurs phases et des matériaux moins coûteux que celui constitutif de la couche mince.

12. Procédé selon l'une des revendications précédentes, **caractérisé par le fait qu'**il comprend une étape de transfert de la couche mince (2) sur un support intermédiaire (12), avant la formation de la couche épaisse (4) sur la couche mince (2).

13. Procédé selon la revendication 12, **caractérisé par le fait que** le support intermédiaire (12) supporte plusieurs couches minces (2).

14. Procédé selon l'une des revendications 12 et 13, **caractérisé par le fait qu'**il comprend une opération consistant à éliminer le support intermédiaire (12).

15. Procédé selon la revendication 14, **caractérisé en ce que** l'élimination du support intermédiaire (12) est réalisée en séparant la couche mince (2) du support intermédiaire (12), afin notamment de recycler ce dernier.

16. Procédé selon l'une des revendications précédentes, **caractérisé par le fait qu'**il comporte une opération de formation d'une couche de liaison (10) sur la couche mince (2) avant qu'elle soit détachée du substrat source (6).

17. Procédé selon l'une des revendications 12 à 16, **caractérisé par le fait qu'**il comporte une opération de formation d'une couche de liaison (11) sur le support intermédiaire (12) avant le transfert de la couche mince (2) sur celui-ci.

18. Procédé selon l'une des revendications 16 et 17, **caractérisé par le fait que** la couche de liaison (10, 11) est composée d'un matériau compris dans la liste comprenant les matériaux amorphes, les matériaux polycristallins et les matériaux métalliques.

19. Procédé selon l'une des revendications précédentes, **caractérisé par le fait que** la couche mince (2) est constituée d'un matériau compris dans la liste comprenant le silicium, le carbure de silicium, le saphir, le diamant, le nitrure de gallium, le nitrure d'aluminium et une combinaison ou une superposition d'au moins deux de ces matériaux.

20. Procédé selon l'une des revendications précédentes, **caractérisé par le fait que** la couche épaisse (4) est formée d'un matériau compris dans la liste comprenant le silicium, le carbure de silicium, le saphir, le diamant, le graphite, le nitrure de gallium, le nitrure d'aluminium et une combinaison ou une superposition d'au moins deux de ces matériaux.

21. Procédé selon l'une des revendications précédentes, **caractérisé par le fait que** la couche mince (2) est détachée du substrat source (6) au niveau d'une zone de fragilisation (8).

22. Procédé selon la revendication 21, **caractérisé par le fait que** la zone de fragilisation (8) est réalisée en implantant, dans ce substrat source (6), des espèces atomiques au voisinage d'une profondeur déterminée.

23. Procédé selon l'une des revendications 1 à 20, **caractérisé par le fait que** la couche mince (2) est détachée du substrat source (6) par élimination, par exemple par attaque chimique, d'une zone intercalée entre la couche mince (2) et le reste du substrat source (6).

24. Procédé selon l'une des revendications précédentes, **caractérisé par le fait que** l'on optimise les conditions de dépôt de la couche épaisse (4) afin que celle-ci corresponde à une qualité particulière comprise dans la liste comprenant les qualités monocristalline, polycristalline, isolante et conductrice.

25. Procédé selon l'une des revendications précédentes, **caractérisé par le fait que** l'on forme la couche épaisse (4) en utilisant la couche mince (2) comme couche germe pour la formation de cette couche épaisse (4).

## Claims

1. A method of fabricating a substrate comprising a thin layer carried by a layer constituting a mechanical support, in particular for optics, electronics, or optoelectronics, the method comprising the following steps:
detaching a layer of material for forming the thin layer (2) from a source substrate (6), then
depositing progressively a material as a thick layer (4), on the thin layer (2), to form the layer which constitutes the mechanical support,
this process being **characterized by** the fact that it includes an operation consisting in depositing a useful layer (16) in semiconductor material on one of the faces of the thin layer (2).

2. A method according to claim 1, **characterized in that** said useful layer (16) is constituted by a crystalline material.

3. A method according to claim 1 or 2, **characterized in that** said useful layer (16) is deposited after the detachment of the thin layer (2) from the source substrate (6).

4. A method according to any preceding claims, **characterized by** the fact that the thick layer (4) is deposited on the thin layer, by a technique taken from the list comprising: chemical vapor deposition, liquid deposition, molecular beam deposition.

5. A method according to anyone of the preceding claims, **characterized by** the fact that it includes an operation consisting in depositing the useful layer (16) on one and on the other face of the thin layer (2).

6. A method according to any of the preceding claims, **characterized by** the fact that the useful layer (16) is deposited before the thick layer (4) is formed.

7. A method according to any of the preceding claims, **characterized by** the fact that the useful layer (16) is deposited after the thick layer (4) has been formed.

8. A method according to any of the preceding claims, **characterized by** the fact that the useful layer (16) is constituted by a material having a large band gap, taken from the list comprising: gallium nitride, aluminum nitride, indium phosphide and gallium arsenide, and compounds of at least to elements taken from the list comprising aluminum, indium, and gallium.

9. A method according to any of the preceding claims, **characterized by** the fact that the useful layer (16) and the thick layer (4) are each deposited on a different face of the thin layer (2).

10. A method according to any of the preceding claims, **characterized by** the fact that the thin layer (2) is constituted by a monocrystalline material.

11. A method according to any of the preceding claims, **characterized by** the fact that the thick layer (4) is formed by depositing a material taken from the list constituted by: monocrystalline materials, polycrystalline materials, amorphous materials, materials comprising a plurality of phases and materials less expensive that the one constituting the thin layer.

12. A method according to any of the preceding claims, **characterized by** the fact that it includes a step of transferring the thin layer (2) onto an intermediate support (12) prior to forming the thick layer (4) on the thin layer (2).

13. A method according to claim 12, **characterized by** the fact that the intermediate support (12) supports a plurality of thin layers (2).

14. A method according to claim 12 or 13, **characterized by** the fact that it includes an operation which consists in eliminating the intermediate support (12).

15. A method according to claim 14, **characterized in that** the intermediate support (12) is eliminated by separating the thin layer (2) from the intermediate support (12), notably to enable the intermediate support to be recycled.

16. A method according to any of the preceding claims, **characterized by** the fact that it includes an operation of forming a bonding layer (10) on the thin layer (2) before it is detached from the source substrate (6).

17. A method according to one of the claims 12 to 16, **characterized by** the fact that it includes an operation of forming a bonding layer (11) on the intermediate support (12) before transferring the thin layer (2) thereon.

18. A method according to claim 16 or claim 17, **characterized by** the fact that the bonding layer (10, 11) is made of a material taken from the list comprising: amorphous materials, polycrystalline materials, and metallic materials.

19. A method according to any of the preceding claims, **characterized by** the fact that the thin layer (2) is constituted by a material taken from the list comprising: silicon, silicon carbide, sapphire, diamond, gallium nitride, aluminum nitride, and a combination or a superposition of at least two of these materials.

20. A method according to any of the preceding claims, **characterized by** the fact that the thick layer (4) is made of a material taken from the list comprising: silicon, silicon carbide, sapphire, diamond, graphite, gallium nitride, aluminum nitride, and a combination or a superposition of at least two of these materials.

21. A method according to any of the preceding claims, **characterized by** the fact that the thin layer (2) is detached from the source substrate (6) via a zone of weakness (8).

22. A method according to claim 21, **characterized by** the fact that the zone of weakness (8) is made by implanting atomic species in the source substrate (6), around a determined depth.

23. A method according to any of the claims 1 or 20, **characterized by** the fact that the thin layer (2) is detached from the source substrate (6) by eliminating a zone interposed between the thin layer (2) and the remainder of the source substrate (6), for example by chemical etching.

24. A method according to any of the preceding claims, **characterized by** the fact that the conditions under which the thick layer (4) is deposited are optimized so that it corresponds to a particular quality taken from the list comprising the following qualities: monocrystalline, polycrystalline, insulating, and conductive.

25. A method according to any of the preceding claims, **characterized by** the fact that the thick layer (4) is formed by using the thin layer (2) as a seed layer for forming said thick layer (4).

## Patentansprüche

1. Verfahren zur Herstellung eines Substrats, das eine dünne Schicht aufweist, die von einer Schicht getragen wird, die einen mechanischen Träger bildet, insbesondere für Optik, Elektronik oder Optoelektronik, wobei das Verfahren die folgenden Schritte aufweist:
- Ablösen einer Schicht eines Materials von einem Quellensubstrat (6), um die dünne Schicht (2) zu bilden, dann
- fortschreitendes Abscheiden eines Materials als eine dicke Schicht (4) auf der dünnen Schicht (2), um die Schicht herzustellen, die den mechanischen Träger bildet,
wobei das Verfahren **dadurch gekennzeichnet ist, dass** es einen Schritt aufweist, der darin besteht, eine Nutzschicht (16) aus Halbleitermaterial auf eine der Flächen der dünnen Schicht (2) abzuscheiden.

2. Verfahren nach Anspruch 1, **dadurch gekennzeichnet, dass** die Nutzschicht (16) in einem kristallinen Material realisiert wird.

3. Verfahren nach Anspruch 1 oder 2, **dadurch gekennzeichnet, dass** die Nutzschicht (16) abgeschieden wird, nachdem die dünne Schicht (2) von dem Quellensubstrat (6) abgelöst worden ist.

4. Verfahren nach einem der vorstehenden Ansprüche, **dadurch gekennzeichnet, dass** die dicke Schicht (4) mit Hilfe einer aus der folgenden Liste ausgewählten Technik auf der dünnen Schicht abgeschieden wird: chemische Gasphasenabscheidungen, Flüssigphasenabscheidungen, Molekularstrahlabscheidungen.

5. Verfahren nach einem der vorstehenden Ansprüche, **dadurch gekennzeichnet, dass** es einen Schritt aufweist, der darin besteht, die Nutzschicht (16) auf der einen und der anderen Fläche der dünnen Schicht (2) abzuscheiden.

6. Verfahren nach einem der vorstehenden Ansprüche, **dadurch gekennzeichnet, dass** die Nutzschicht (16) abgeschieden wird, bevor die dicke Schicht (4) gebildet wird.

7. Verfahren nach einem der vorstehenden Ansprüche, **dadurch gekennzeichnet, dass** die Nutzschicht (16) abgeschieden wird, nachdem die dicke Schicht (4) gebildet worden ist.

8. Verfahren nach einem der vorstehenden Ansprüche, **dadurch gekennzeichnet, dass** die Nutzschicht (16) aus einem aus der folgenden Liste ausgewählten Material mit großer Bandlücke, nämlich Galliumnitrid, Aluminiumnitrid, Indiumphosphid und Galliumarsenid, und den Verbindungen von mindestens zwei aus der folgenden Liste ausgewählten Elementen, nämlich Aluminium, Indium und Gallium, besteht.

9. Verfahren nach einem der vorstehenden Ansprüche, **dadurch gekennzeichnet, dass** die Nutzschicht (16) und die dicke Schicht (4) jeweils auf einer unterschiedlichen Fläche der dünnen Schicht (2) abgeschieden werden.

10. Verfahren nach einem der vorstehenden Ansprüche, **dadurch gekennzeichnet, dass** die dünne Schicht (2) aus einem monokristallinen Material besteht.

11. Verfahren nach einem der vorstehenden Ansprüche, **dadurch gekennzeichnet, dass** die dicke Schicht (4) durch Abscheiden eines aus der folgenden Liste ausgewählten Materials gebildet wird: monokristalline Materialien, polykristalline Materialien, amorphe Materialien, mehrere Phasen aufweisende Materialien und Materialien, die kostengünstiger sind als das die dünne Schicht bildende Material.

12. Verfahren nach einem der vorstehenden Ansprüche, **dadurch gekennzeichnet, dass** es einen Schritt einer Übertragung der dünnen Schicht (2) auf einen Zwischenträger (12) auf weist, bevor die dicke Schicht (4) auf der dünnen Schicht (2) gebildet wird.

13. Verfahren nach Anspruch 12, **dadurch gekennzeichnet, dass** der Zwischenträger (12) mehrere dünne Schichten (2) trägt.

14. Verfahren nach einem der Ansprüche 12 und 13, **dadurch gekennzeichnet, dass** es einen Schritt aufweist, der darin besteht, den Zwischenträger (12) zu beseitigen.

15. Verfahren nach Anspruch 14, **dadurch gekennzeichnet, dass** das Beseitigen des Zwischenträgers (12) dadurch realisiert wird, dass die dünne Schicht (2) von dem Zwischenträger (12) getrennt wird, insbesondere um letzteren wiederzuverwenden.

16. Verfahren nach einem der vorstehenden Ansprüche, **dadurch gekennzeichnet, dass** es einen Schritt einer Herstellung einer Verbindungsschicht (10) auf der dünnen Schicht (2) aufweist, bevor sie von dem Quellensubstrat (6) abgelöst wird.

17. Verfahren nach einem der Ansprüche 12 bis 16, **dadurch gekennzeichnet, dass** es einen Schritt einer Herstellung einer Verbindungsschicht (11) auf dem Zwischenträger (12) aufweist, bevor die dünne Schicht (2) auf diesen übertragen wird.

18. Verfahren nach einem der Ansprüche 16 und 17, **dadurch gekennzeichnet, dass** die Verbindungsschicht (10,11) aus einem aus der folgenden Liste ausgewählten Material besteht: amorphe Materialien, polykristalline Materialien und metallische Materialien.

19. Verfahren nach einem der vorstehenden Ansprüche, **dadurch gekennzeichnet, dass** die dünne Schicht (2) aus einem aus der folgenden Liste ausgewählten Material besteht: Silizium, Siliziumcarbid, Saphir, Diamant, Galliumnitrid, Aluminiumnitrid und eine Kombination oder eine Übereinanderschichtung von mindestens zwei dieser Materialien.

20. Verfahren nach einem der vorstehenden Ansprüche, **dadurch gekennzeichnet, dass** die dicke Schicht (4) aus einem aus der folgenden Liste ausgewählten Material besteht: Silizium, Siliziumcarbid, Saphir, Diamant, Graphit, Galliumnitrid, Aluminiumnitrid und eine Kombination oder eine Übereinanderschichtung von mindestens zwei dieser Materialien.

21. Verfahren nach einem der vorstehenden Ansprüche, **dadurch gekennzeichnet, dass** in Höhe einer Versprödungszone (8) die dünne Schicht (2) von dem Quellensubstrat (6) abgelöst wird.

22. Verfahren nach Anspruch 21, **dadurch gekennzeichnet, dass** die Versprödungszone (8) dadurch realisiert wird, dass in dieses Quellensubstrat (6) Atome in die Nachbarschaft einer vorgegebenen Tiefe implantiert werden.

23. Verfahren nach einem der Ansprüche 1 bis 20, **dadurch gekennzeichnet, dass** die dünne Schicht (2) dadurch von dem Quellensubstrat (6) abgelöst wird, dass eine zwischen der dünnen Schicht (2) und dem Rest des Quellensubstrats (6) angeordnete Zone zum Beispiel durch einen chemischen Angriff beseitigt wird.

24. Verfahren nach einem der vorstehenden Ansprüche, **dadurch gekennzeichnet, dass** die Abscheidungsbedingungen zum Abscheiden der dicken Schicht (4) optimiert werden, so dass diese einer aus der folgenden Liste ausgewählten besonderen Eigenschaft entspricht: monokristalline, polykristalline, isolierende und leitfähige Eigenschaft.

25. Verfahren nach einem der vorstehenden Ansprüche, **dadurch gekennzeichnet, dass** die dicke Schicht (4) gebildet wird, indem die dünne Schicht (2) als Keim fi,ir die Bildung dieser dicken Schicht (4) verwendet wird.
